(19) Europäisches Patentamt
European Patent Office
Office européen des brevets

(11) **EP 2 953 035 A1**

(12) **EUROPÄISCHE PATENTANMELDUNG**

(43) Veröffentlichungstag:
09.12.2015 Patentblatt 2015/50

(51) Int Cl.:
**G06F 17/12** (2006.01)    **G06F 17/50** (2006.01)

(21) Anmeldenummer: **15166175.8**

(22) Anmeldetag: **04.05.2015**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA**

(30) Priorität: **04.06.2014 DE 102014210640**

(71) Anmelder: **Robert Bosch GmbH**
**70442 Stuttgart (DE)**

(72) Erfinder:
• **Rittel, Michael**
**71706 Markgroeningen (DE)**
• **Von Vietinghoff, Anne**
**71272 Renningen (DE)**
• **Oehlerking, Jens**
**70499 Stuttgart (DE)**
• **Bleile, Thomas**
**70435 Stuttgart-Zuffenhausen (DE)**
• **Behle, Markus**
**70188 Stuttgart (DE)**
• **Butz, Martin**
**71711 Steinheim An Der Murr (DE)**

(54) **VERFAHREN UND VORRICHTUNG ZUM VISUALISIEREN EINES GLEICHUNGSSYSTEMS**

(57) Die Erfindung hat ein Verfahren mit den folgenden Merkmalen zum Gegenstand: Jede Gleichung (42) eines Gleichungssystems wird durch eine erste Form dargestellt; jede Variable (40, 46) desselben Gleichungssystems wird durch mindestens eine zweite Form dargestellt und mit jeder Gleichung (42), welche die Variable (40, 46) beinhaltet, durch eine Verbindungslinie (20) eines ersten Linientyps verbunden; alle Eingangsvariablen (46) unter den Variablen (40, 46) werden mit einer ersten Markierung versehen und jede anhand der Gleichungen (42) aus den Eingangsvariablen (46) mittels einer Berechnungsvorschrift bestimmbare Variable (40) wird mit einer zweiten Markierung versehen.

Die Erfindung hat ferner eine zur Durchführung eines derartigen Verfahrens eingerichtete Vorrichtung, ein entsprechendes Computerprogramm (10) sowie ein maschinenlesbares Speichermedium mit einem solchen Computerprogramm (10) zum Gegenstand.

**FIG. 13**

EP 2 953 035 A1

**Beschreibung**

Die vorliegende Erfindung betrifft ein Verfahren nach dem Oberbegriff des Patentanspruchs 1. Die Erfindung betrifft ferner eine zur Durchführung eines derartigen Verfahrens eingerichtete Vorrichtung, ein entsprechendes Computerprogramm sowie ein maschinenlesbares Speichermedium mit einem solchen Programm.

Stand der Technik

Eine auf mathematischer Notation basierende Beschreibung eines Systems, etwa aus der Elektrotechnik, Physik, Biologie oder den Sozialwissenschaften, wird gemeinhin unter dem Oberbegriff des mathematischen Modells zusammengefasst. Mathematische Modelle finden Anwendung in unterschiedlichsten Problembereichen und ermöglichen deren systematische Erforschung mit mathematischen Methoden. Der Prozess der Erstellung eines derartigen Modells wird als Modellierung bezeichnet.

Ein vor allem zur Beschreibung dynamischer Systeme häufig gewähltes Modell ist das eines mathematischen Gleichungssystems. Praktische Bedeutung kommt insbesondere den zur Modellierung unterschiedlichster naturwissenschaftlicher Systeme genutzten gewöhnlichen Differentialgleichungen (englisch *ordinary differential equations,* ODE) sowie den an algebraische Nebenbedingungen gekoppelten differentialalgebraischen Gleichungen (englisch *differential algebraic equations,* DAE) zu.

Als problematisch erweist sich in diesem Bereich in erster Linie die Beherrschbarkeit naturgetreuer mathematischer Modelle. So lässt in zahlreichen Problembereichen die Dimensionalität selbst vergleichsweise einfacher Systeme ein intuitives Verständnis der zur Modellierung verwendeten Gleichungssysteme nahezu unmöglich erscheinen. Allein die Fragen nach der Konsistenz eines vorgeschlagenen Modells und der Bestimmbarkeit der identifizierten Systemvariablen mögen den Systemanalysten in solchen Fällen vor schier unlösbare Probleme stellen.

WO2006050173A3 schlägt zur Beantwortung derartiger Fragen ein Programm vor, welches die Konsistenz eines gegebenen mathematischen Modells überprüft und bei dessen festgestellter Inkonsistenz zumindest ein alternatives Modell anbietet. Das vorgeschlagene Programm bestimmt zudem, ob das Modell auf eine konkrete Berechnungsanforderung des Benutzers die Bestimmung einer konkreten Variablen unterstützt.

Offenbarung der Erfindung

Die vorliegende Erfindung entstand vor dem Hintergrund des vorstehend beschriebenen Stands der Technik. Ihr lag dabei die Aufgabe zugrunde, geeignete Mittel bereitzustellen, um selbst hochkomplexe Gleichungssysteme in eine visuell erfassbare Form überführen zu können.

Die Erfindung geht aus von einem Verfahren mit den Merkmalen des Anspruchs 1, einer Vorrichtung mit den Merkmalen des Anspruchs 8, einem Computerprogramm mit den Merkmalen des Anspruchs 9 sowie einem Speichermedium mit den Merkmalen des Anspruchs 10.

Ein Vorzug dieser Lösung liegt in der intuitiven Erfassbarkeit der erfindungsgemäß erzeugten Darstellung. Insbesondere gestattet sie es einem Betrachter der resultierenden Visualisierung, zulässige Berechnungsanforderungen an das Modell unmittelbar aus dessen Ansicht abzuleiten. Vor allem die Tätigkeit des Systemanalytikers wird auf diesem Wege maßgeblich vereinfacht.

Weitere vorteilhafte Ausgestaltungen der Erfindung sind in den Unteransprüchen angegeben. So erlaubt es die Weiterbildung nach Patentanspruch 2 bei gegebenen Eingangsvariablen, die Abhängigkeiten der Gleichungen und übrigen Systemvariablen - gleichsam den Informationsfluss bei der auf eine Berechnungsanforderung erfolgenden Auswertung des Gleichungssystems - auf anschauliche Weise zu verdeutlichen.

Einem anderen Zweck dient die Hervorhebung intrinsischer sowie resultierender algebraischer Schleifen, wie sie der Anspruch 3 zum Gegenstand hat. Insofern versetzt das Bewusstsein um entsprechende Strukturen den Analytiker in die Lage, die darin begründeten Einschränkungen des Modells bereits im Ansatz zu erkennen. Diese Erkenntnis wiederum gestattet eine zielgerichtete Anpassung des Modells, falls Zyklen dieser Art dessen Brauchbarkeit beeinträchtigen.

Der Prozess der Modellierung wird ebenfalls durch eine Ausführungsform des erfindungsgemäßen Verfahrens gemäß Anspruch 4 erleichtert. Dabei steht die grafische Kennzeichnung einer etwaigen lokalen Überbestimmtheit des betrachteten Gleichungssystems im Vordergrund. Derartige Inkonsistenzen des Modells, welche dessen praktischer Anwendung grundsätzlich entgegenstehen, lassen sich auf diese Weise bereits in einer frühen Phase des Entwurfs auflösen.

Zwei für dynamische Systeme vorteilhafte Ausgestaltungen bilden die Gegenstände der Ansprüche 5 und 6. Insofern handelt es sich um besonders innovative Erweiterungen der bekannten mathematischen Metamodelle, um diese auf die Anforderungen jenseits der statischen Analyse vorzubereiten. Insbesondere ermöglichen die entsprechenden Ausführungsformen den Brückenschlag von einer rein strukturellen Visualisierung hin zu einem ausführbaren und somit ungleich wertvolleren Simulationsmodell.

Schließlich trägt auch ein Verfahren nach Anspruch 7 den Anforderungen des Praktikers besondere Rechnung, indem es den Einfluss der Veränderung einer gegebenen Eingangsvariable auf die übrigen Systemvariablen in das vorgeschlagene Metamodell integriert. Eine derart gestützte Sensitivitätsanalyse, wie sie etwa in den Wirtschaftswissenschaften gebräuchlich ist, findet auch im Rahmen der Modellierung technischer Systeme vielfältige Anwendung.

## Kurze Beschreibung der Zeichnungen

Ein Ausführungsbeispiel der Erfindung ist in der Zeichnung dargestellt und wird im Folgenden näher beschrieben.

Figur 1 zeigt eine erste erfindungsgemäße Visualisierung eines ersten Gleichungssystems.

Figur 2 zeigt eine zweite Visualisierung des ersten Gleichungssystems.

Figur 3 zeigt eine dritte Visualisierung des ersten Gleichungssystems.

Figur 4 zeigt eine vierte Visualisierung des ersten Gleichungssystems.

Figur 5 zeigt die Visualisierung eines zweiten Gleichungssystems.

Figur 6 zeigt die Visualisierung eines dritten Gleichungssystems.

Figur 7 zeigt die Visualisierung eines vierten Gleichungssystems.

Figur 8 zeigt die Visualisierung eines fünften Gleichungssystems.

Figur 9 zeigt die Visualisierung eines sechsten Gleichungssystems.

Figur 10 zeigt die Visualisierung eines siebten Gleichungssystems.

Figur 11 zeigt die Visualisierung eines achten Gleichungssystems.

Figur 12 zeigt die Visualisierung eines neunten Gleichungssystems.

Figur 13 ist ein Bildschirmabzug eines zur Durchführung des erfindungsgemäßen Verfahrens eingerichteten Computerprogramms.

Figur 14 ist ein Bildschirmabzug eines zur Simulation des visualisierten Modells verwendeten Simulators.

## Ausführungsformen der Erfindung

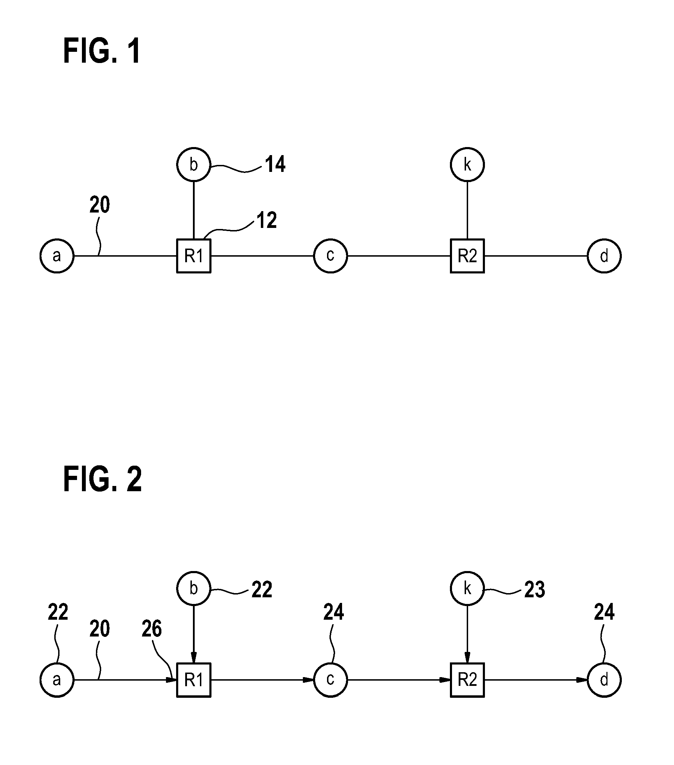

Figur 1 illustriert anhand eines einfachen Gleichungssystems den grundlegenden Ansatz des erfindungsgemäßen Verfahrens. Dem Szenario liegt die Annahme zweier gegebener Gleichungen $c = ab$ sowie $d = k - c$ zugrunde, die nachfolgend mit den Bezugzeichen R1 und R2 bezeichnet und abbildungsgemäß durch jeweils eine erste Form 12 in Gestalt eines Rechtecks dargestellt werden. Die verwendeten Variablen a, b, c, d, k werden ihrerseits durch jeweils eine zweite, nunmehr runde Form 14 dargestellten, wobei für die Zwecke der nachfolgenden

Beschreibung vereinfachend die jeweiligen mathematischen Objekte und die sie repräsentierenden Formen sprachlich gleichgesetzt werden.

Als wesentlich erweist sich die topologische Anordnung und wechselseitige Verbindung der Gleichungen R1, R2 und Variablen a, b, c, d, k gemäß der in Rede stehenden Visualisierung. In diesen Punkten orientiert sich die Erfindung an der von George Friedman im Zuge seiner Constraint-Theorie entwickelten Notation, wie sie auch den Figuren der eingangs gewürdigten WO2006050173A3 zugrunde liegt. Auf die diesbezüglichen Passagen der Beschreibung jener Patentanmeldung wird daher vollumfänglich Bezug genommen.

In Anlehnung an das zitierte Metamodell beruht auch die erfindungsgemäße Visualisierung gemäß Figur 1 im Kern auf einem bipartiten oder paaren Graphen, dessen Partitionen die Mengen der Gleichungen R1, R2 sowie der Variablen a, b, c, d, k bilden. Jede Kante des Graphen - dargestellt durch eine Verbindungslinie 20 eines ersten Linientyps - verbindet somit grundsätzlich eine Gleichung R1, R2 mit einer in dieser Gleichung vorkommenden Variablen a, b, c, d, k, sodass die Gleichungen gemäß einer ersten Form 12 und die Variablen gemäß einer zweiten Form 14 die Knoten des Graphen konstituieren. Das erfindungsgemäße Verfahren definiert gleichwohl einige Erweiterungen dieser graphentheoretischen Eigenheiten, welche nunmehr anhand der folgenden Figuren betrachtet werden.

Figur 2 gibt eine zweite Visualisierung desselben Gleichungssystems wieder, in welcher die vorgesehenen Eingangsvariablen a, b, k mit einer (ersten) Markierung 22, 23 versehen wurden. Die Eingangsvariablen a, b wurden dabei als veränderlich identifiziert, während die Eingangsvariable k als konstant angenommen werden soll. Entsprechend unterscheidet sich die Markierung 22 der Eingangsvariablen a, b von jener Markierung 23 der Eingangsvariablen k.

Die gewählten Eingangsvariablen a, b, k sowie die Struktur des Gleichungssystems bedingt es in diesem Fall, zur Bestimmung der Variablen d zunächst die Variable c gemäß der - der Gleichung R1 entsprechenden - Berechnungsvorschrift $c := ab$ und erst dann die Variable d - entsprechend R2 - mit dem Wert $d := k - c$ zu belegen.

Diesem zwingenden Informationsfluss trägt die Visualisierung Rechnung, indem einerseits die bestimmbaren Variablen c, d mit einer zweiten Markierung 24 versehen werden. Andererseits werden auch die Verbindungslinien 20 jeweils mit einem Richtungshinweis 26 in Gestalt einer Pfeilspitze versehen. Im Falle der Variablen a etwa weist dieser Richtungshinweis 26 von der Variablen fort in Richtung der sie enthaltenden Gleichung R1, da die Berechnungsvorschrift *c := ab* eine Auswertung der Variablen a anhand der Gleichung R1 vorsieht.

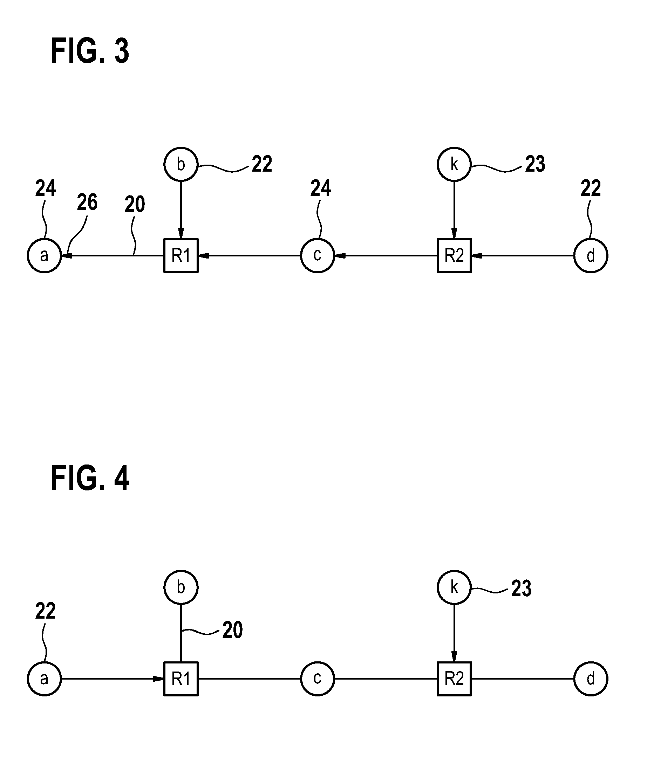

Gerade umgekehrt verhält es sich im Szenario der Figur 3, in welchem anstelle der Variablen a die Eingangsvariable d mit der ersten Markierung 22 versehen wurde. Eine die Variable a betreffende Berechnungsvorschrift würde in diesem Fall eine Zuweisung an die Variable a anhand der zu $a := \frac{c}{b}$ umgeformten Gleichung R1 umfassen. Diesen Umstand spiegelt der Richtungshinweis 26 von der Gleichung R1 in Richtung der Variablen a sowie deren zweite Markierung 24 wider.

Figur 4 veranschaulicht anhand einer vierten Visualisierung, dass ein entsprechender (in Figur 4 nicht dargestellter) Richtungshinweis 26 an den die Variablen b, c, d verbindenden Verbindungslinien 20 gänzlich unterbleibt, sofern die betreffende Variable b, c, d nicht anhand der Gleichungen R1, R2 bestimmt werden kann. Im vorliegenden Fall eines insgesamt unterbestimmten Gleichungssystems entfällt damit ebenfalls der Anlass zur Anbringung einer (in Figur 4 nicht dargestellten) zweiten Markierung 24 jedweder Knoten b, c, d.

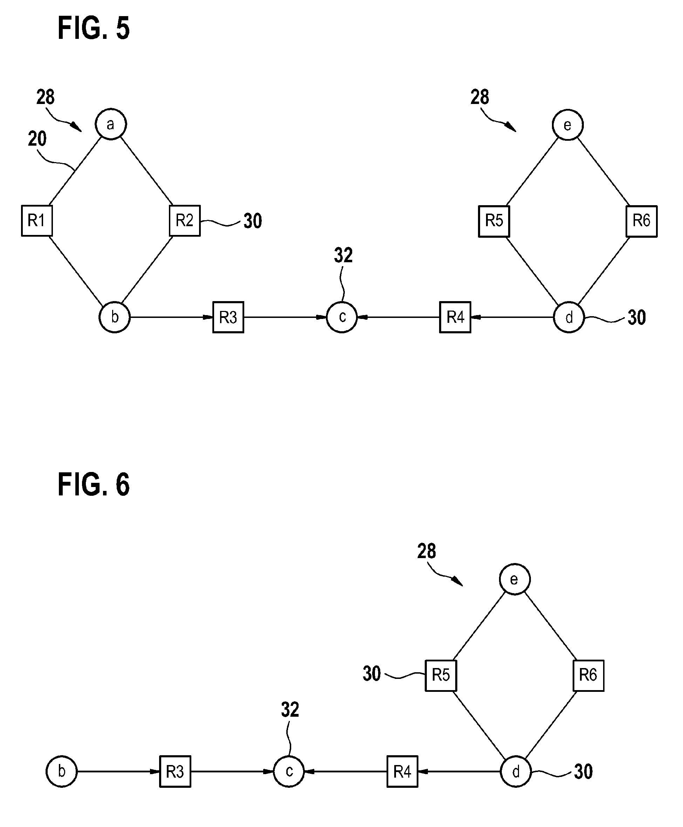

Besonderes Augenmerk kommt im Rahmen des erfindungsgemäßen Verfahrens der Untersuchung des Gleichungssystems auf mögliche BNS (*basic nodal squares*) zu. Hierunter versteht man eine Teilmenge des Gleichungssystems, die strukturell gemeinsam gelöst werden muss. Algebraische Schleifen und punktbestimmte Unterräume sind Beispiele für BNS. Figur 5 zeigt hierzu beispielhaft die erfindungsgemäße Visualisierung eines Gleichungssystems, welches durch das Zusammenwirken zweier intrinsischer algebraischer Schleifen 28 geprägt ist. Die von beiden Schleifen umfassten Gleichungen R1, R2, R5, R6 und Variablen a, b, d, e sowie die entsprechenden Verbindungslinien 20 wurden dementsprechend mit einer dritten Markierung 30 versehen.

Der Graph der Figur 5 kann dabei zugleich als Beispiel für die Darstellung eines überbestimmten Gleichungssystems dienen. Insofern stehen die intrinsischen algebraischen Schleifen 28 als solche der Bestimmbarkeit der Variablen a, b, c, d, e zwar nicht zwingend im Wege, sondern erfordern zu ihrer Berechnung lediglich eine zusammenhängende Betrachtung. Im vorliegenden Szenario jedoch führt die zweifache Abhängigkeit der Variablen c von den Gleichungen R3, R4 und den mit diesen verbundenen Schleifen 28 zu einem strukturell unauflösbaren Widerspruch, in dessen Folge die überbestimmte Variable c mit einer vierten Markierung 32 versehen wird.

Ähnlich verhält es sich im Fall des in Figur 6 visualisierten Gleichungssystems. In diesem Szenario ist zwar lediglich eine algebraische Schleife 28 über die Gleichung R4 mit der Variablen c verbunden. Deren Überbestimmung ergibt sich gleichwohl angesichts der Eingangsvariablen b in Verbindung mit der Gleichung R3, sodass auch hier eine Kennzeichnung der überbestimmten Variablen c mit der vierten Markierung 32 erfolgt.

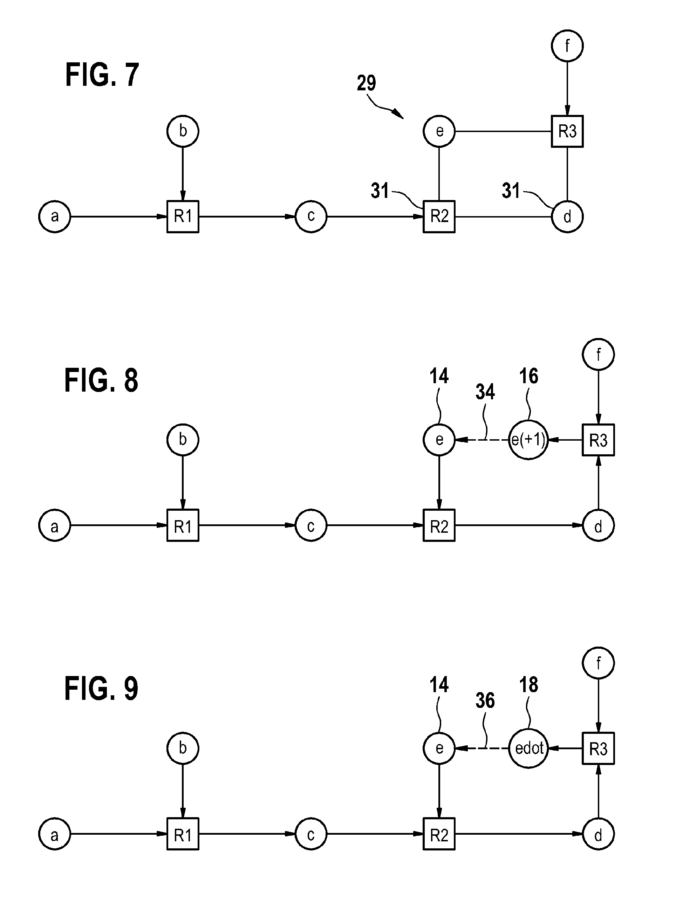

Ein anderer Sachverhalt ergibt sich im an sich wohlgeformten Gleichungssystem gemäß Figur 7, dem die Eingangsvariablen a, b, f zugrunde liegen. Erst anhand dieser Eingangsvariablen a, b, f wurde erfindungsgemäß eine aus den Variablen d, e und den Gleichungen R2, R3 bestehende algebraische Schleife 29 erkannt, welche der Bestimmbarkeit der Variablen c indes nicht entgegen steht. Es handelt sich bei der Schleife 29 demnach nicht um eine intrinsische, sondern vielmehr um eine sogenannte resultierende algebraische Schleife, deren Knoten d, e, R2, R3 folglich mit einer dritten Markierung 31 versehen werden.

Zwei bemerkenswerte Erweiterungen der aus der Constraint-Theorie vertrauten Notation seien nunmehr anhand der Figuren 8 und 9 erläutert. In beiden Szenarien handelt es sich bei der Variablen e um eine zeitabhängige Variable. Diese wird im Fall der Figur 8 jedoch nicht nur in einem gegenwärtigen Zeitpunkt durch eine zweite Form 14, sondern auch in einem früheren Zeitpunkt durch eine zweite Form 16 dargestellt, welche zur Unterscheidung mit "e(-1)" bezeichnet ist. Um der auf diese Weise modellierten zeitlichen Verzögerung zwischen den Bezugsgrößen der Formen 14, 16 zusätzlich Ausdruck zu verleihen, werden diese durch eine Verbindungslinie 34 eines zweiten, beispielsweise punktierten Linientyps verbunden.

In der Figur 9 hingegen wird der zeitabhängigen Variablen e - abermals dargestellt durch die zweite Form 14 - ihre Ableitung edot - nunmehr repräsentiert durch die zweite Form 18 - beigefügt. Die Verbindungslinie 36 der Formen 14, 18 entspricht dabei einem dritten Linientyp, der als Integration von edot auf e verstanden werden kann.

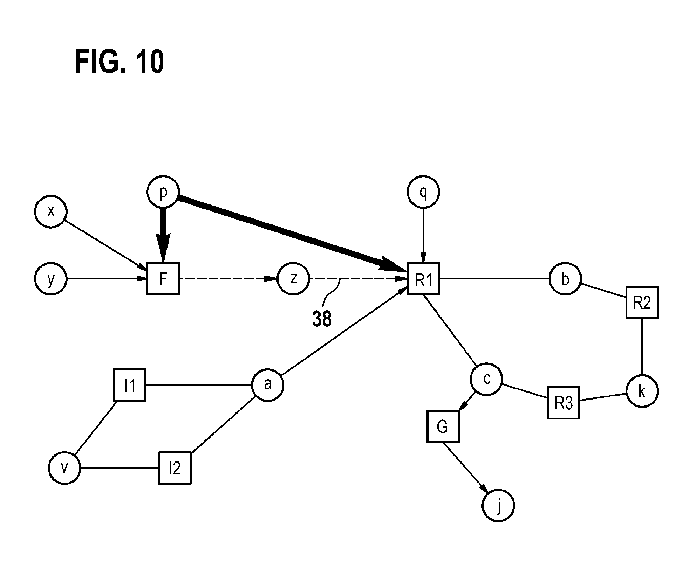

Figur 10 gibt eine für die Praxis nützliche erfindungsgemäße Visualisierung der dynamischen Eigenschaften des zugrunde liegenden Gleichungssystems wieder. In Bezug auf die Eingangsvariable p wurde hier die Sensitivität insbesondere der Variablen z untersucht. Deren Verbindungslinien wurden daraufhin mit einem der ermittelten Sensitivität entsprechenden optischen Merkmal 38 ausgeführt, z.B. hier die Stärke.

Eine derartige dynamische Analyse des Gleichungssystems erfordert zunächst eine algebraische Lösung der Gleichungen F, G, I1, I2, R1, R2, R3 mittels geeigneter Äquivalenzumformungen, wie sie beispielsweise in gängigen Computeralgebrasystemen (CAS) realisiert ist. Als Ergebnis einer solchen "Kausalisierung" des Modells kann jeder bestimmbaren Variablen *y* eine Funktion $y = f(x_1,...,x_n)$ zugeordnet werden. Nunmehr wird vom Benutzer gewählt, welche Variablenänderungen in welche Richtungen (steigend/fallend) untersucht werden sollen. Dies geschieht, indem für jede Eingangsvariable ein Wert vorgegeben wird. Dieser Wert gibt die Stärke der Veränderung an dieser Variablen an; wird 0 gewählt, so bedeutet dies also keine Veränderung. Eine positive Zahl bedeutet ein Ansteigen und eine negative ein Abfallen der betreffenden Variablen. Sodann wird die Sensitivität $s_y$ von $y$ gemäß folgendem Schema errechnet:

$$s_y = \sum_{i=1}^{n} \frac{\partial f}{\partial x_i}(x_1, \ldots, x_n) \cdot s_{x_i}$$

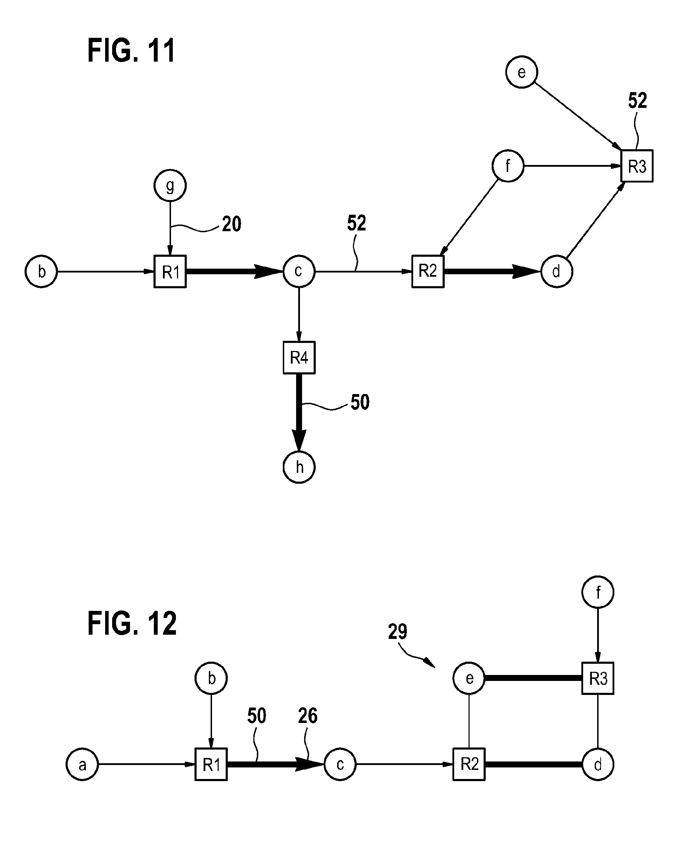

Figur 11 zeigt das Ergebnis einer Dulmage-Mendelsohn-Zerlegung zur Bestimmung eines maximalen Matchings, wie sie in A. L. Dulmage, N. S. Mendelsohn Coverings of bipartite graphs, Canad. J. Math., Band 10, 1958, S. 517 - 534 beschrieben ist. Die vom Matching umfassten Kanten werden mittels einer fünften Markierung 50 der entsprechenden Verbindungslinien 20 kenntlich gemacht, während ein als überbestimmt erkannter Teil des Modells durch eine sechste Markierung 52 der betreffenden Verbindungslinien hervorgehoben ist. Auch die Gleichung R3 trägt dabei die sechste Markierung 52 als Hinweis auf den Umstand, dass eine Elimination dieser Gleichung R3 die Konsistenz des Modells herstellen könnte.

Auch in der Visualisierung der Figur 12 kennzeichnet die sechste Markierung 52 eine vom Matching umfasste Kante des Graphen. Die entsprechende Verbindungslinie wurde zudem mit einem Richtungshinweis 26 gekennzeichnet, während die resultierende algebraische Schleife 29 frei von Richtungshinweisen 26 bleibt.

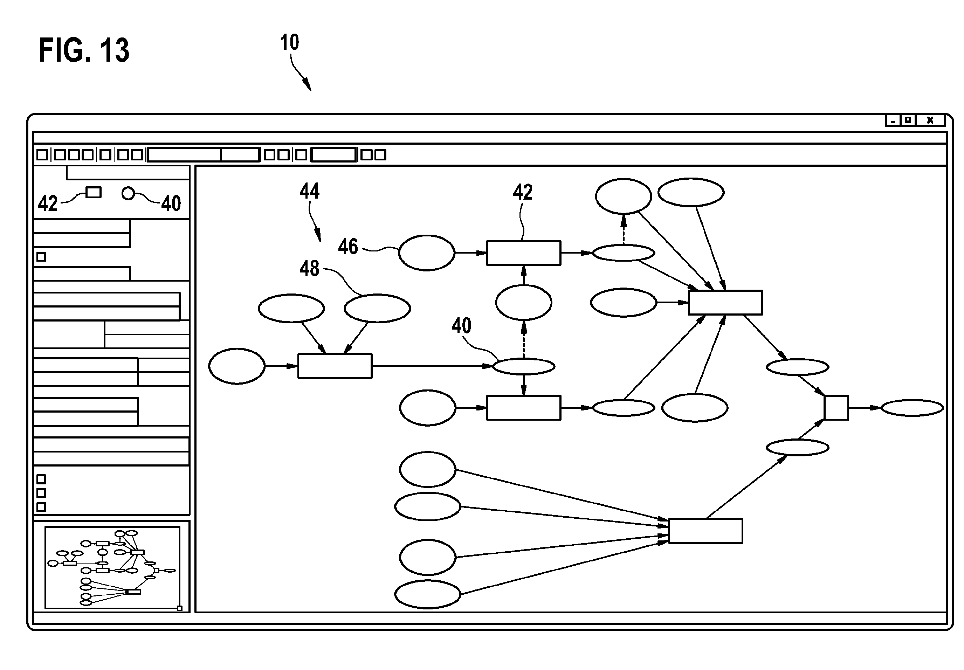

Figur 13 zeigt den Bildschirmabzug eines zur Durchführung des erfindungsgemäßen Verfahrens eingerichteten Computerprogramms 10. Die in Figur 13 lediglich schematisch angedeuteten Variablen 40 und Gleichungen 42 lassen sich mittels des Computerprogramms 10 interaktiv auf einer Zeichenfläche 44 platzieren und mit konkreten Inhalten hinterlegen. Alternativ kann ein Benutzer auch lediglich die Gleichungen 42 in Formelschreibweise angeben und dem Computerprogramm 10 die symbolische Erkennung der verwendeten Variablen 40 und die topologische Anordnung der Knoten 40, 42 auf der Zeichenfläche 44 übertragen.

Das Computerprogramm 10 erlaubt ebenfalls eine durch den Benutzer gesteuerte Markierung der Eingangsvariablen 46 und -konstanten 48 sowie deren Belegung mit konkreten Eingabewerten oder -wertebereichen. Die der weiteren Visualisierung zugrunde liegende Untersuchung der Konsistenz und Berechenbarkeit des Modells kann gemäß der klassischen Constraint-Theorie oder der oben zitierten Dulmage-Mendelsohn-Zerlegung erfolgen.

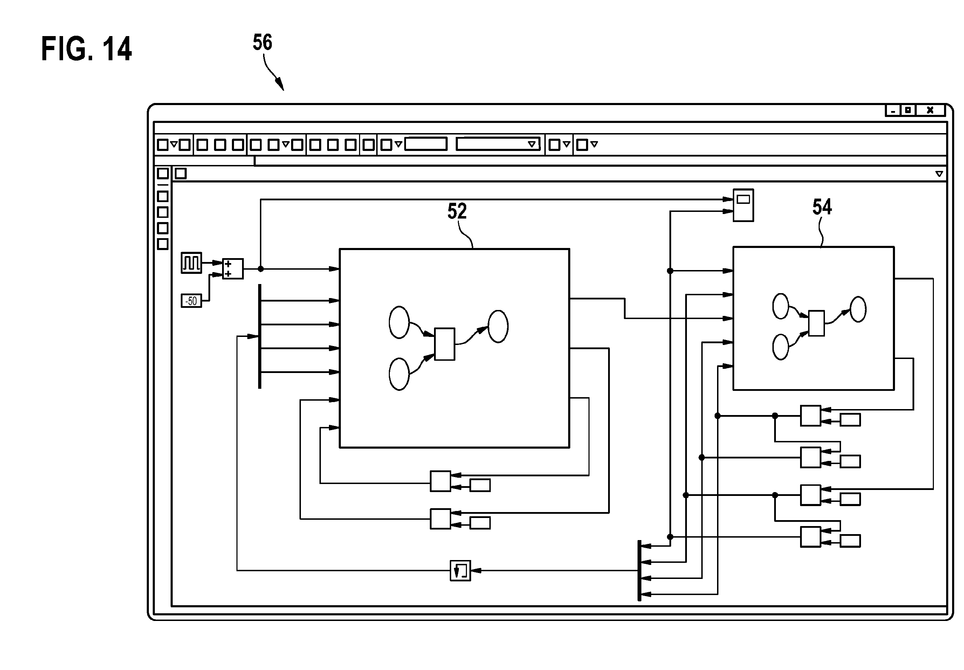

Das der Figur 13 zugrunde liegende Gleichungssystem beschreibt dabei einen Regler 52 für eine Regelstrecke 54, der, wie die Figur 14 zeigt, mittels eines von dem Computerprogramm 10 erzeugten Datenformates unmittelbar einem zeitgesteuerten Simulator 56 zugeführt werden kann. Ein einschlägiges Softwareprodukt wird etwa von dem Hersteller *The MathWorks, Inc.* des verbreiteten Numerikpakets MATLAB als Zusatzpaket unter dem Handelsnamen Simulink vertrieben.

**Patentansprüche**

1. Verfahren zum Visualisieren eines mehrere Gleichungen (R1, R2, R3, R4, R5, R6, F, G, I1, 12) und mehrere Variablen (a, b, c, d, e, f, h, j, k, p, q, v, x, y) umfassenden Gleichungssystems, **gekennzeichnet durch** folgende Merkmale:

   - jede Gleichung (R1, R2, R3, R4, R5, R6, F, G, I1, 12, 42) wird **durch** eine erste Form (12) dargestellt,
   - jede Variable (a, b, c, d, e, f, h, j, k, p, q, v, x, y, 40, 46) wird **durch** mindestens eine zweite Form (14, 16, 18) dargestellt und mit jeder Gleichung (R1, R2, R3, R4, R5, R6, F, G, I1, 12, 42), welche die Variable (a, b, c, d, e, f, h, j, k, p, q, v, x, y, 40, 46) enthält, **durch** eine Verbindungslinie (20) eines ersten Linientyps verbunden,
   - alle Eingangsvariablen (a, b, d, e, f, g, k, p, q, x, y, 46) unter den Variablen (a, b, c, d, e, f, h, j, k, p, q, v, x, y, 40, 46) werden mit einer ersten Markierung (22, 23) versehen und
   - jede anhand der Gleichungen (R1, R2, R3, R4, R5, R6, F, G, I1, 12, 42) aus den Eingangsvariablen (a, b, d, e, f, g, k, p, q, x, y, 40) mittels einer Berechnungsvorschrift bestimmbare Variable (a, c, d, h, j, z, 40) wird mit einer zweiten Markierung (24) versehen.

2. Verfahren nach Anspruch 1, **gekennzeichnet durch** folgende Merkmale:

   - die eine Variable (a, b, c, d, e, f, h, j, k, p, q, v, x, y, 40, 46) mit einer Gleichung (R1, R2, R3, R4, R5, R6, F, G, I1, 12, 42) verbindende Verbindungslinie (20) umfasst einen Richtungshinweis (26), wenn die Berechnungsvorschrift von der Variablen (a, b, c, d, e, f, h, j, k, p, q, v, x, y, 42, 46) und der Gleichung (R1, R2, R3, R4, R5, R6, F, G, I1, 12, 40) abhängt,
   - der Richtungshinweis (26) weist auf die Variable (a, b, c, d, e, f, h, j, k, p, q, v, x, y, 40, 46) hin, wenn die Berechnungsvorschrift eine Zuweisung an die Variable (a, b, c, d, e, f, h, j, k, p, q, v, x, y, 40, 46) anhand der Gleichung (R1, R2, R3, R4, R5, R6, F, G, I1, 12, 42) umfasst und
   - der Richtungshinweis (26) weist von der Variablen (a, b, c, d, e, f, h, j, k, p, q, v, x, y, 40, 46) fort, wenn die Berechnungsvorschrift eine Auswertung der Variablen (a, b, c, d, e, f, h, j, k, p, q, v, x, y, 40, 46) anhand der Gleichung (R1, R2, R3, R4, R5, R6, F, G, I1, 12, 42) umfasst.

3. Verfahren nach Anspruch 1 oder 2, **gekennzeichnet durch** folgende Merkmale:

   - das Gleichungssystem wird auf vorkommende BNS (28, 29) hin untersucht und

- die von den BNS (28, 29) umfassten Gleichungen (R1, R2, R3, R4, R5, R6, F, G, I1, I2, 42) und Variablen (a, b, c, d, e, f, h, j, k, p, q, v, x, y, 40, 46) werden mit einer dritten Markierung (30, 31) versehen.

4. Verfahren nach einem der Ansprüche 1 bis 3, **gekennzeichnet durch** folgende Merkmale:

    - das Gleichungssystem wird auf eine **durch** die Gleichungen (R1, R2, R3, R4, R5, R6, F, G, I1, I2, 42) überbestimmte Variable (c) hin untersucht und
    - die überbestimmte Variable (c) wird mit einer vierten Markierung (32) versehen.

5. Verfahren nach einem der Ansprüche 1 bis 4, **gekennzeichnet durch** folgende Merkmale:

    - eine zeitabhängige Variable (e) wird in einem ersten Zeitpunkt und in einem zweiten Zeitpunkt **durch** jeweils eine zweite Form (14, 16) dargestellt und
    - die Variable (e) in dem ersten Zeitpunkt wird mit der Variablen (e) in dem zweiten Zeitpunkt **durch** eine Verbindungslinie (34) eines zweiten Linientyps verbunden.

6. Verfahren nach einem der Ansprüche 1 bis 4, **gekennzeichnet durch** folgende Merkmale:

    - eine zeitabhängige Variable (e) und ihre Ableitung (edot) werden **durch** jeweils eine zweite Form (14, 18) dargestellt und
    - die Variable (e) und ihre Ableitung (edot) werden **durch** eine Verbindungslinie (36) eines dritten Linientyps verbunden.

7. Verfahren nach einem der Ansprüche 1 bis 6, **gekennzeichnet durch** folgende Merkmale:

    - für eine Eingangsvariable (a, b, d, e, f, g, k, p, q, x, y, 46) und mindestens eine bestimmbare Variable (a, c, d, h, j, z, 40) wird eine Sensitivität der bestimmbaren Variablen (a, c, d, h, j, z, 40) bezüglich der Eingangsvariablen (a, b, d, e, f, g, k, p, q, x, y, 46) untersucht und
    - die die bestimmbare Variable (a, b, d, e, f, g, k, p, q, x, y, 40) verbindenden Verbindungslinien (20, 34, 36) werden mit einer von der Sensitivität abhängigen optischen Markierung (38) ausgeführt.

8. Vorrichtung zum Visualisieren eines mehrere Gleichungen (R1, R2, R3, R4, R5, R6, F, G, I1, I2) und mehrere Variablen (a, b, c, d, e, f, h, j, k, p, q, v, x, y) umfassenden Gleichungssystems, insbesondere mittels eines Verfahrens nach einem der Ansprüche 1 bis 7, **gekennzeichnet durch** folgende Merkmale:

    - Mittel zum Darstellen der Gleichungen (R1, R2, R3, R4, R5, R6, F, G, I1, I2, 42) **durch** eine erste Form (12),
    - Mittel zum Darstellen der Variablen (a, b, c, d, e, f, h, j, k, p, q, v, x, y, 40, 46) **durch** jeweils mindestens eine zweite Form (14, 16, 18) und zum Verbinden der jeweiligen Variablen (a, b, c, d, e, f, h, j, k, p, q, v, x, y, 40, 46) mit jeder Gleichung (R1, R2, R3, R4, R5, R6, F, G, I1, I2, 42), welche die jeweilige Variable (a, b, c, d, e, f, h, j, k, p, q, v, x, y, 40, 46) beinhaltet, **durch** eine Verbindungslinie (20) eines ersten Linientyps,
    - Mittel zum Versehen aller Eingangsvariablen (a, b, d, e, f, g, k, p, q, x, y, 46) unter den Variablen (a, b, c, d, e, f, h, j, k, p, q, v, x, y, 40, 46) mit einer ersten Markierung (22, 23) und
    - Mittel zum Versehen der anhand der Gleichungen (R1, R2, R3, R4, R5, R6, F, G, I1, I2, 42) aus den Eingangsvariablen (a, b, d, e, f, g, k, p, q, x, y, 46) mittels einer Berechnungsvorschrift bestimmbaren Variablen (a, c, d, h, j, z, 40) mit einer zweiten Markierung (24).

9. Computerprogramm (10), welches dazu eingerichtet ist, alle Schritte eines Verfahrens nach einem der Ansprüche 1 bis 7 durchzuführen.

10. Maschinenlesbares Speichermedium mit einem darauf gespeicherten Computerprogramm (10) nach Anspruch 9.

FIG. 1

FIG. 2

# FIG. 3

# FIG. 4

FIG. 5

FIG. 6

## FIG. 7

## FIG. 8

## FIG. 9

# FIG. 10

## FIG. 11

## FIG. 12

FIG. 13

10

42

40

46

44

48

40

42

FIG. 14

EP 2 953 035 A1

**Europäisches Patentamt**
**European Patent Office**
**Office européen des brevets**

## EUROPÄISCHER RECHERCHENBERICHT

Nummer der Anmeldung

EP 15 16 6175

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A,D | WO 2006/050173 A2 (FRIEDMAN GEORGE [US]) 11. Mai 2006 (2006-05-11) * Abbildungen 1-8 * ----- | 1-10 | INV. G06F17/12 G06F17/50 |

RECHERCHIERTE SACHGEBIETE (IPC)

G06F

Der vorliegende Recherchenbericht wurde für alle Patentansprüche erstellt

| Recherchenort | Abschlußdatum der Recherche | Prüfer |
|---|---|---|
| Berlin | 31. August 2015 | Domingo Vecchioni, M |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
...........................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 15 16 6175

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-08-2015

| Im Recherchenbericht angeführtes Patentdokument | Datum der Veröffentlichung | Mitglied(er) der Patentfamilie | Datum der Veröffentlichung |
|---|---|---|---|
| WO 2006050173 A2 | 11-05-2006 | KEINE | |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

*   WO 2006050173 A3

**In der Beschreibung aufgeführte Nicht-Patentliteratur**

*   **A. L. DULMAGE ; N. S. MENDELSOHN.** Coverings of bipartite graphs. *Canad. J. Math.,* 1958, vol. 10, 517-534